# EUROPEAN PATENT SPECIFICATION

(11) **EP 4 123 392 B1**
(45) Date of publication and mention of the grant of the patent: **03.09.2025**
(21) Application number: 22185543.0
(22) Date of filing: 18.07.2022
(51) Int. Cl.: G04B 17/04, G04B 18/00, G04B 17/06

(54) **METHOD OF MANUFACTURING A PLURALITY OF MECHANICAL RESONATORS IN A MANUFACTURING WAFER**
VERFAHREN ZUR HERSTELLUNG EINER VIELZAHL MECHANISCHER RESONATOREN IN EINEM HERSTELLUNGSWAFER
PROCÉDÉ DE FABRICATION D'UNE PLURALITÉ DE RÉSONATEURS MÉCANIQUES DANS UNE TRANCHE DE FABRICATION

(30) Priority: 20.07.2021 NL 2028796
(43) Date of publication of application: 25.01.2023
(73) Proprietor: Flexous Mechanisms IP B.V., 2629 JD Delft (NL)
(72) Inventor: Giuffre, Eola Jessica, 2629 JD Delft (NL); Lustig, Maarten Pieter, 2629 JD Delft (NL)
(74) Representative: De Vries & Metman

(56) References cited:
- EP-A1- 3 182 213
- WO-A1-2017/068538
- WO-A2-2015/132259
- CH-A- 339 574
- CH-A2- 709 291

## Description

The invention relates to a method of manufacturing a plurality of mechanical resonators in a manufacturing wafer, the resonators being intended to equip a regulating member of a timepiece, the method comprising the step of fabricating a plurality of resonators in at least one wafer according to reference specifications.

WO2021/053501 teaches such a method, wherein the step
a) fabricating of a plurality of resonators in at least one reference wafer according to reference specifications comprising at least one step of lithography to form patterns of the resonators on or above said reference wafer and a step of machining in said reference wafer through said patterns; is followed by the steps
(b) for the at least one reference plate, to establish a map indicative of the dispersion of stiffnesses of the resonators with respect to an average stiffness value;
(c) dividing the mapping into fields and determining a correction to be implemented to the dimensions of the resonators for at least one of said fields in order to reduce said dispersion;
(d) modifying the reference specifications for the lithography step to implement the dimensional corrections for said at least one field in the lithography step;
(e) fabricate resonators on a build wafer using the modified specifications.

A problem with the method known from WO2021/053501 is that it is not possible to compensate each or practically each single resonator so that it will exhibit a frequency close to specification.

It is therefore an object of the invention to make it possible to compensate each single resonator or at least most resonators and bring it as close as possible to specification.

According to the invention this object is achieved with the method according to one or more of the appended claims.

The invention is primarily embodied in a method in accordance with claim 1. Accordingly this provides a coarse tuning step before the final tuning step.

It is preferred to provide a wafer from silicon or a SOI wafer. This supports antimagnetic behaviour and provides high elasticity to keep hold on the tuning masses.

It is further preferable that before applying step (d), the resonators can be subjected to the step of oxidizing the resonators and/or depositing silicon oxide on the resonators followed by controlled removal of silicon oxide to provide the, preferably all resonators with a silicon oxide layer thickness which brings the, preferably all resonators closer to reference specifications.

It is preferred that before applying step (d) the individual groups are processed to a target frequency, preferably with a spread of 1 Hz or less. In an embodiment, the groups are processed by oxidizing the resonators and/or depositing silicon oxide on the resonators followed by controlled removal of silicon oxide to the target frequency.

According to the invention for each resonator that is compensated for symmetry reasons preferably two or a multiple of two masses are applied.

In certain embodiments it is preferable to apply at least two masses from a series of tuning masses, wherein each of the masses has a center of mass which is external of a geometric center of the mass, and that the masses that are applied to the resonator are rotated so as to finetune the resonator closer to its reference specifications.

With the method of the invention it is possible to provide that the series of tuning masses cover a range of the resonator of 10-15% of the reference specifications of the resonator.

It is preferable that adjacent masses in the series of tuning masses have different weights so as to enable tuning of the resonator with a frequency-step of 0.5% of the reference specifications of the resonator.

In one embodiment exactly two masses are applied for tuning the resonator closer to its reference specifications. As already mentioned above two masses are needed for symmetry (each mass applied on each mass of the resonator). If only one tuning mass would be used, this could create internal stress on the resonator with rising temperature and thus adversely affect the accuracy.

Suitably the masses have a tolerance of 10% with respect to design weight. This copes with manufacturing and assembly errors and ensures that the orientation error remains low.

It is further preferred that a tuning range of each mass overlaps between 0 and 50% with a tuning range of an adjacent mass in the series of tuning masses. This way manufacturing tolerances of the tuning masses can be easily dealt with.

It is further preferable that adding the tuning masses to the resonator increases the moment of inertia of the resonator in comparison with the same resonator without tuning masses by at least 1-100% or preferably by 1-30%. This is especially advantageous for lower frequency resonators or when one wants to use less groups of tuning masses. The frequency of the resonator can then be reduced without making use of thinner beams which will benefit the robustness of the resonator and reduces the chance for manufacturing errors.

One embodiment of the method of the invention is characterized by applying three masses on at least one of the resonators for tuning the resonator frequency and for tuning an orientation sensitivity of the resonator.

Another embodiment of the method of the invention is characterized by applying on at least one of the resonators three masses, wherein one mass of said three masses is applied to set the frequency of the resonator to a desired frequency, and two tuning masses of said three masses are applied to finetune the frequency of the resonator.

WO 2017/068538 discloses an oscillator for adjusting a mechanical timepiece movement, the oscillator comprising an escapement wheel and a resonator that forms the time base of the oscillator; the resonator including a mass element that is kept in oscillation by at least two vibrating elements; the mass element including at least one anchor portion that is rigidly connected to the mass element, and is configured so as to directly engage with the escapement wheel in order to maintain oscillations of the resonator. The oscillator is made from a single substrate, preferably a glass, ceramic, glass-ceramic or silicon substrate, the latter in the form of a wafer. The moment of inertia of the mass element can be modified by adding or removing weights on the mass element.

CH 709 291 relates to a rotating oscillator for a timepiece comprising a support element designed to allow the oscillator to be assembled on a timepiece, a balance, a plurality of flexible blades connecting the support element to the balance and able to exert a return torque on the balance, and a felloe mounted secured to the balance.

EP 3 182 213 relates to a mechanism for adjusting an average speed in a timepiece movement comprises an escapement wheel and a mechanical oscillator, in which a plurality of blades, which are resiliently flexible in an oscillation plane, support and return a balance in such a way that this balance oscillates at an angle in the oscillation plane. A pallet fork comprises two rigid pallets which are rigidly connected to the balance and are arranged to co-operate alternately with a toothing of the escapement wheel when the balance oscillates at an angle.

US 2021/0026299 relates to a method including the following steps: a) providing a substrate including a first silicon layer, a second silicon layer and an intermediate silicon oxide layer therebetween; b) etching the first silicon layer in order to form the timepiece components therein; c) releasing from the substrate a wafer formed by at least all or part of the etched, first silicon layer and including the timepiece components; d) thermally oxidizing and then deoxidizing the timepiece components; e) forming by thermal oxidation or deposition a silicon oxide layer on the timepiece components; f) detaching the timepiece components from the wafer.

The invention will hereinafter be further elucidated with reference to exemplary embodiments of a method according to the invention that is not limiting as to the appended claims.

The following elucidation is made with reference to the drawing in which:
- figures 1A and 1B shows a wafer with resonators to be tuned with tuning masses according to the invention;
- figure 2 shows grouped resonators with tuning masses;
- figure 3 shows a resonator provided with two tuning masses; and
- figure 4 shows a possible frequency spread covered by the tuning masses.

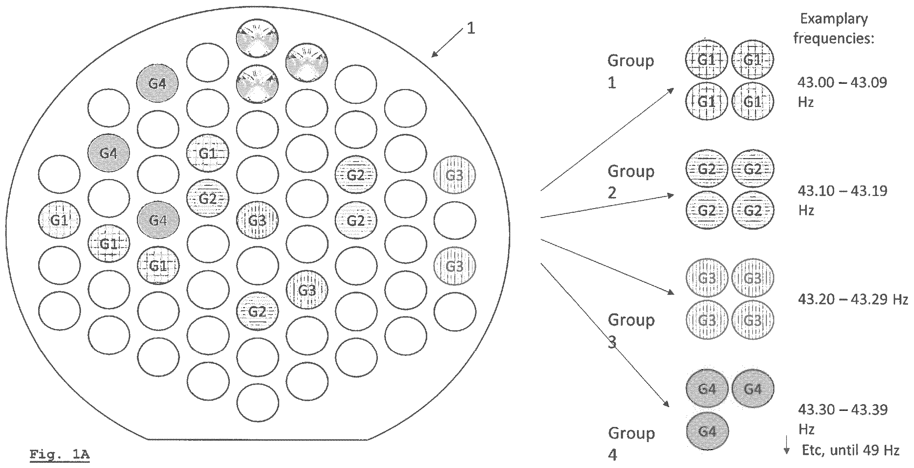

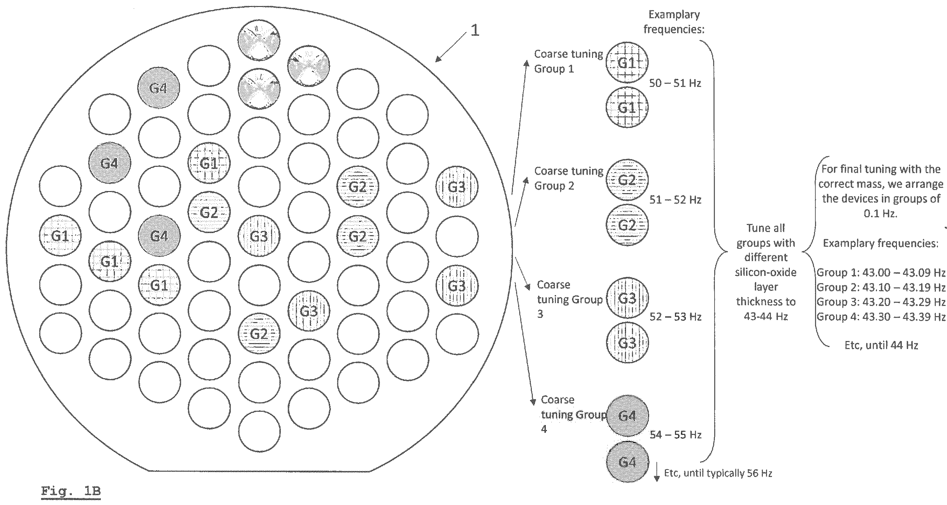

The resonators can for instance be manufactured in a lithography process or in any other suitable manufacturing method providing a wafer 1 with resonators. This is shown in figure 1A and figure 1B. The wafer 1 as is shown in figures 1A and 1B is preferably from silicon or is a SOI wafer. It is clearly shown that when still in the wafer 1, the resonators G1 - G4 are randomly distributed.

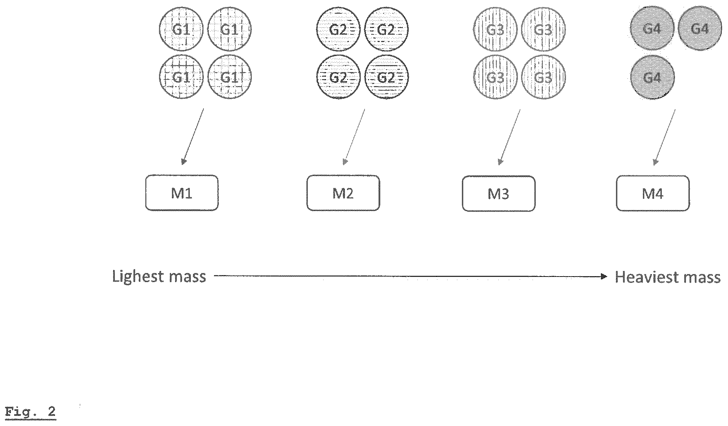

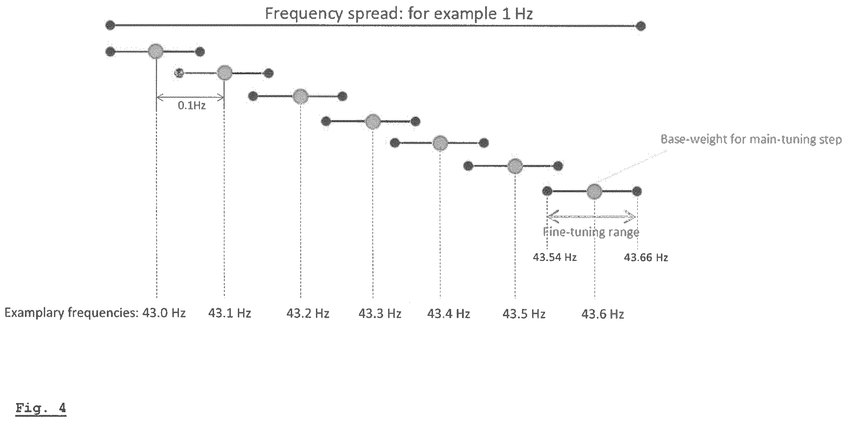

Two different methods of manufacturing are possible, the first method being more elaborate than the second method and exhibiting the following steps:
a. Manufacturing resonators in a wafer 1; the resulting resonators are distributed over a frequency range (e.g. having a spread of for instance ~ 6 Hz), see figure 1B.
b. Taking all resonators from the wafer 1.
c. Measuring the natural frequency of each resonator.
d. Grouping the resonators with similar frequencies, e.g. in coarse tuning groups G1, G2, G3, G4 etc. of for instance ~ 1 Hz (e.g. 50.0-51.0 Hz, 51.0-52.0 Hz, 53.0-54.0 Hz, and 54.0 Hz-55.0 Hz). This is shown on the right hand side in figure 1B.
e. Process the groups by oxidizing the resonators and/or depositing silicon oxide and removing silicon oxide to a target frequency with a spread of maximum for instance ~ 1 Hz (resulting e.g. in a reduction of the total spread from 6 Hz to 1 Hz).
f. Pick the right masses for each oscillator (e.g. from a series of, e.g. 10, masses - M1, M2, M3, etc - of increasing weight, see figure 2) to compensate for the offset with the target resonating frequency according to specification. For reasons of accuracy it is desirable that each tuning mass can tune a Δ of for instance 0.1 Hz. Desirably a series of 10 tuning masses is used which covers a 1 Hz spread around the target design frequency - this is shown in figure 4.

In a second, faster manufacturing method according to the invention, the following steps can be distinguished:
a. Manufacturing resonators in a wafer 1; the resulting resonators are distributed over a frequency range (e.g. having a spread of for instance ~ 6 Hz), see figure 1A.
b. Measuring all individual resonators while still part of the wafer 1.
c. Taking all resonators from the wafer 1; grouping the resonators with similar frequencies, e.g. in tuning groups G1, G2, G3, G4 etc.
d. Pick the right masses (from a series of 60 masses) for each resonator to compensate for the offset with the target design frequency according to specification; this is shown in figure 1A which relates to grouping the resonators G1 - G4 with similar frequencies in fine tuning groups of for instance ~ 0.1 Hz.

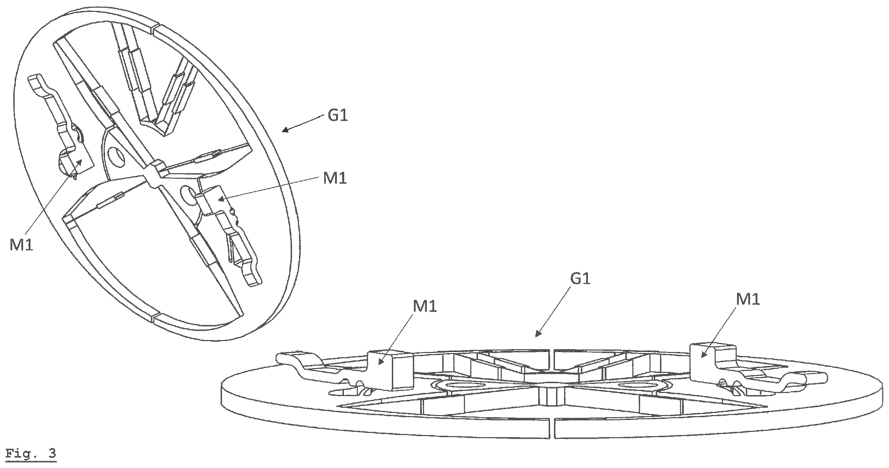

To summarize: both figure 1A and figure 1B depict the result of manufacturing a plurality of mechanical resonators G1 - G4 in a manufacturing wafer 1, wherein the resonators G1 - G4 are manufactured according to reference specifications, and wherein subsequently the steps are applied of
- measuring the actual frequency of each of the plurality of resonators G1 - G4; followed by
- determining the offset of the actual frequency of the resonators G1 - G4 with respect to the reference specifications; and
- applying on (at least one of) the resonators G1 - G4 at least two masses M1 (as shown in figure 3) from a series of tuning masses to compensate the offset of the concerning resonator G1 - G4 so as to bring the resonator G1 - G4 closer to the reference specifications.

It will be clear for the skilled person from figure 3 that each of the masses M1 has a center of mass which is external of a geometric center of the mass, and that the masses M1 that are applied to the resonator G1 - G4 are rotated while applied on the resonator G1 - G4 so as to finetune the resonator G1 - G4 closer to its reference specifications.

Preferably the series of tuning masses M1, M2, M3, etc. as depicted in figure 2 cover a range of the resonator G1 - G4 of max. 15% of the reference specifications of the resonator. Further it is desirable that adjacent masses M1, M2 or M2, M3, etc. in the series of tuning masses M1 - M4 have different weights so as to enable tuning of each resonator G1 - G4 with a frequency-step of 0.5% of the reference specifications of the resonator. With a design frequency for instance of 50 Hz, the tuning frequency range is preferably 2 Hz, and the frequency step will then be 0.2 Hz. Different values are however evidently feasible, as is shown in the exemplary embodiment of figures 1A, 1B and 4.

With reference to figure 3 it is preferred that the at least two masses M1 have a mutual weight difference of less than 0,5 %. Also in this figure the embodiment is depicted in which exactly two masses M1 are applied for tuning the resonator G1 closer to its reference specifications. This can however also be a multiple of two masses M1.

Desirably the respective masses have a tolerance of 10% with respect to their design weight.

Figure 4 depicts that a tuning range of each mass overlaps between 0 and 50% with a tuning range of an adjacent mass in the series of tuning masses. This is depicted by the centroid frequencies 43.0 Hz, 43.1 Hz, 43.2 Hz etc. The centroid frequency is in the middle of a tuning range, and neighbouring tuning ranges are clearly overlapping.

It is preferred that by adding the tuning masses to the resonator G1 - G4 a moment of inertia of the resonator G1 - G4 increases in comparison with the same resonator without tuning masses by 1-30%, or preferably by at least 1-100%.

Although the invention has been discussed in the foregoing with reference to exemplary embodiments of the method of the invention, the invention is not restricted to these particular embodiments which can be varied in many ways without departing from the invention. The discussed exemplary embodiments shall therefore not be used to construe the appended claims strictly in accordance therewith. On the contrary the embodiments are merely intended to explain the wording of the appended claims without intent to limit the claims to these exemplary embodiments. The scope of protection of the invention shall therefore be construed in accordance with the appended claims only, wherein a possible ambiguity in the wording of the claims shall be resolved using these exemplary embodiments.

It is for instance within the scope of the invention to apply three tuning masses on at least one of the resonators for tuning the resonator frequency and for tuning an orientation sensitivity of the resonator.

It is also within the scope of the invention to apply three masses on at least one of the resonators, wherein one mass of said three masses is applied to set the frequency of the resonator close to its reference specifications, and two masses of said three tuning masses are applied to finetune the frequency of the resonator even closer to the resonator's reference specifications.

## Claims

1. A method of manufacturing a plurality of mechanical resonators (G1 - G4) in a manufacturing wafer (1), the resonators (G1 - G4) being intended to equip a regulating member of a timepiece, the method comprising the following steps:
(a) fabricating a plurality of resonators (G1 - G4) in at least one wafer (1) according to reference specifications;
(b) measuring an actual frequency of each of the plurality of resonators (G1 - G4);
(c) determining an offset of the actual frequency of the resonators (G1 - G4) with respect to the reference specifications;
(d) applying on at least one of the resonators (G1 - G4) at least two masses from a series of tuning masses (M1 - M4) to compensate the offset of the concerning resonator (G1 - G4) to bring the resonator (G1 - G4) closer to the reference specifications and, before applying step (d) the resonators are sorted in groups (G1 - G4), wherein the resonators in a particular group have a first offset from the reference specifications within a predefined first range, which first offset within the predefined first range differs from a second offset within a predefined second range of the resonators in a second group.

2. The method according to claim 1, **characterized by** providing a wafer (1) from silicon or a SOI wafer.

3. The method according to claim 1 or 2, **characterized in that** before applying step (d) the resonators are subjected to the step of controlled oxidizing the resonators and/or depositing silicon oxide on the resonators followed by controlled removal of silicon oxide to provide all resonators with a silicon oxide layer thickness which brings all resonators closer to reference specifications.

4. The method according to any one of claims 1 - 3, wherein before applying step (d) the groups are processed to a target frequency, preferably with a spread of 1 Hz or less.

5. The method according to claim 4, wherein the groups are processed by oxidizing the resonators and/or depositing silicon oxide on the resonators followed by controlled removal of silicon oxide to the target frequency.

6. The method according to any one of claims 1 - 5, **characterized by** applying the at least two masses from a series of tuning masses (M1 - M4), wherein each of the masses (M1 - M4) has a center of mass which is external of a geometric center of the mass, and that the masses (M1 - M4) that are applied to the resonator (G1 - G4) are rotated so as to finetune the resonator (G1 - G4) closer to its reference specifications.

7. The method according to any one of claims 1 - 6, **characterized by** providing that the series of tuning masses (M1 - M4) cover a range of the resonator (G1 - G4) of max. 15 % of the reference specifications of the resonator (G1 - G4).

8. The method according to any one of claims 1 - 7, **characterized by** providing that adjacent masses (M1, M2; M2, M3; M3, M4; etc.) in the series of tuning masses (M1 - M4) have different weights so as to enable tuning of the resonator (G1 - G4) with a frequency-step of 0,5% of the reference specifications of the resonator (G1 -G4).

9. The method according to any one of claims 1 - 8, **characterized by** providing that exactly two masses or a multiple of two masses are applied for tuning the resonator (G1 - G4) closer to its reference specifications.

10. The method according to any one of claims 1 - 9, **characterized by** providing that the masses (M1 - M4) have a tolerance of 10% with respect to their design weight.

11. The method according to any one of claims 1 - 10, **characterized by** providing that a tuning range of each mass (M1 - M4) overlaps between 0 and 50% with a tuning range of an adjacent mass in the series of tuning masses (M1 - M4).

12. The method according to any one of claims 1 - 11, **characterized by** providing that adding the tuning masses (M1 - M4) to the resonator (G1 - G4) increases a moment of inertia of the resonator in comparison with the same resonator without tuning masses by at least 1-100%, preferably by 1-30%.

13. The method according to any one of claims 1 - 12, **characterized by** applying on at least one of the resonators (G1 - G4) three masses for tuning the resonator frequency and an orientation sensitivity of the resonator.

14. The method according to any one of claims 1 - 13, **characterized by** applying on at least one of the resonators (G1 - G4) three masses, wherein one mass of said three masses is applied to set the frequency of the resonator (G1 - G4) close to its reference specifications, and two masses of said three tuning masses are applied to finetune the frequency of the resonator (G1 - G4) even closer to the resonator's reference specifications.

## Patentansprüche

1. Verfahren zum Herstellen einer Mehrzahl von mechanischen Resonatoren (G1 - G4) in einem Fertigungswafer (1), wobei die Resonatoren (G1 - G4) zur Ausstattung eines Regulierelements einer Uhr vorgesehen sind, wobei das Verfahren die folgenden Schritte umfasst:
(a) Herstellen einer Mehrzahl von Resonatoren (G1 - G4) in mindestens einem Wafer (1) gemäß Referenzspezifikationen,
(b) Messen einer tatsächlichen Frequenz jedes der Mehrzahl von Resonatoren (G1 - G4),
(c) Ermitteln einer Abweichung der tatsächlichen Frequenz der Resonatoren (G1 - G4) bezüglich der Referenzspezifikationen,
(d) Anbringen von mindestens zwei Massen aus einer Reihe von Abstimmmassen (M1 - M4) an mindestens einem der Resonatoren (G1 - G4), um die Abweichung des betreffenden Resonators (G1 - G4) zu kompensieren, um den Resonator (G1-G4) näher an die Referenzspezifikationen heranzubringen, wobei vor dem Durchführen von Schritt
(d) die Resonatoren in Gruppen (G1 - G4) sortiert werden, wobei die Resonatoren in einer bestimmten Gruppe eine erste Abweichung gegenüber den Referenzspezifikationen innerhalb eines vordefinierten ersten Bereichs haben, wobei sich diese erste Abweichung innerhalb des vordefinierten ersten Bereichs von einer zweiten Abweichung innerhalb eines vordefinierten zweiten Bereichs der Resonatoren in einer zweiten Gruppe unterscheidet.

2. Verfahren gemäß Anspruch 1, **gekennzeichnet durch** Bereitstellen eines Wafers (1) aus Silizium oder eines SOI-Wafers.

3. Verfahren gemäß Anspruch 1 oder 2, **dadurch gekennzeichnet, dass** vor dem Durchführen von Schritt (d) die Resonatoren dem Schritt eines kontrollierten Oxidierens der Resonatoren und/oder eines Aufbringens von Siliziumoxid auf die Resonatoren unterzogen werden, gefolgt von einem kontrollierten Entfernen des Siliziumoxids, um alle Resonatoren mit einer Siliziumoxidschichtdicke zu versehen, die alle Resonatoren näher an die Referenzspezifikationen heranbringt.

4. Verfahren gemäß irgendeinem der Ansprüche 1 - 3, wobei vor dem Durchführen von Schritt (d) die Gruppen auf eine Zielfrequenz bearbeitet werden, vorzugsweise mit einer Streuung von 1 Hz oder weniger.

5. Verfahren gemäß Anspruch 4, wobei die Gruppen bearbeitet werden durch Oxidieren der Resonatoren und/oder Aufbringen von Siliziumoxid auf die Resonatoren, gefolgt von kontrolliertem Entfernen des Siliziumoxids auf die Zielfrequenz.

6. Verfahren gemäß irgendeinem der Ansprüche 1 - 5, **gekennzeichnet durch** Anbringen der mindestens zwei Massen aus einer Reihe von Abstimmmassen (M1 - M4), wobei jede der Massen (Ml - M4) einen Massenschwerpunkt hat, der außerhalb eines geometrischen Massenschwerpunkts liegt, und dass die Massen (Ml - M4), die an dem Resonator (G1 - G4) angebracht werden, gedreht werden, um den Resonator (G1 - G4) näher an seine Referenzspezifikationen heran feinabzustimmen.

7. Verfahren gemäß irgendeinem der Ansprüche 1 - 6, **gekennzeichnet durch** Bereitstellen, dass die Reihe von Abstimmmassen (Ml - M4) einen Bereich des Resonators (G1 - G4) von maximal 15 % der Referenzspezifikationen des Resonators (G1 - G4) abdecken.

8. Verfahren gemäß irgendeinem der Ansprüche 1 - 7, **gekennzeichnet durch** Bereitstellen, dass benachbarte Massen (Ml, M2; M2, M3; M3, M4; usw.) in der Reihe von Abstimmmassen (M1 - M4) unterschiedliche Gewichte haben, um ein Abstimmen des Resonators (G1 - G4) mit einem Frequenzschritt von 0,5% der Referenzspezifikationen des Resonators (G1 - G4) zu ermöglichen.

9. Verfahren gemäß irgendeinem der Ansprüche 1 - 8, **gekennzeichnet durch** Bereitstellen, dass genau zwei Massen oder ein Vielfaches von zwei Massen verwendet werden, um den Resonator (G1 - G4) näher an seine Referenzspezifikationen heran abzustimmen.

10. Verfahren gemäß irgendeinem der Ansprüche 1 - 9, **gekennzeichnet durch** Bereitstellen, dass die Massen (Ml-M4) eine Toleranz von 10 % bezüglich ihres Konstruktionsgewichts aufweisen.

11. Verfahren gemäß irgendeinem der Ansprüche 1 - 10, **gekennzeichnet durch** Bereitstellen, dass ein Abstimmbereich jeder Masse (M1 bis M4) zwischen 0 und 50% mit einem Abstimmbereich einer benachbarten Masse in der Reihe der Abstimmmassen (M1 bis M4) überlappt.

12. Verfahren gemäß irgendeinem der Ansprüche 1 - 11, **gekennzeichnet durch** Bereitstellen, dass das Hinzufügen der Abstimmmassen (Ml - M4) zum Resonator (G1 - G4) ein Trägheitsmoment des Resonators im Vergleich zum gleichen Resonator ohne Abstimmmassen um mindestens 1 bis 100%, vorzugsweise um 1 bis 30%, erhöht.

13. Verfahren gemäß irgendeinem der Ansprüche 1 - 12, **gekennzeichnet durch** Anbringen dreier Massen an mindestens einem der Resonatoren (G1 - G4) zum Abstimmen der Resonator-Frequenz und einer Orientierungsempfindlichkeit des Resonators.

14. Verfahren gemäß irgendeinem der Ansprüche 1 - 13, **gekennzeichnet durch** Anbringen dreier Massen an mindestens einem der Resonatoren (G1 - G4), wobei eine Masse der drei Massen angebracht wird, um die Frequenz des Resonators (G1 - G4) nahe an dessen Referenzspezifikationen einzustellen, und zwei der drei Abstimmmassen angebracht werden, um die Frequenz des Resonators (G1 - G4) noch näher an die Referenzspezifikationen des Resonators heran feinabzustimmen.

## Revendications

1. Procédé de production d'une pluralité de résonateurs (G1-G4) mécaniques dans une tranche de production (1), les résonateurs (G1-G4) étant destinés à équiper un organe de régulation d'une pièce d'horlogerie, le procédé comprenant les étapes suivantes :
(a) la fabrication d'une pluralité de résonateurs (G1-G4) dans au moins une tranche (1) selon des spécifications de référence ;
(b) la mesure d'une fréquence effective de chacun de la pluralité de résonateurs (G1-G4) ;
(c) la détermination d'un décalage de la fréquence effective des résonateurs (G1-G4) par rapport aux spécifications de référence ;
(d) l'application sur au moins l'un des résonateurs (G1-G4) d'au moins deux masses d'une série de masses (M1-M4) de réglage pour compenser le décalage du résonateur (G1-G4) concerné pour rapprocher le résonateur (G1-G4) des spécifications de référence et, avant l'étape d'application
(e) les résonateurs sont triés en groupes (G1-G4), dans lequel les résonateurs dans un groupe particulier ont un premier décalage par rapport aux spécifications de référence dans une première plage prédéfinie, lequel premier décalage dans la première plage prédéfinie diffère d'un deuxième décalage dans une deuxième plage prédéfinie des résonateurs dans un deuxième groupe.

2. Procédé selon la revendication 1, **caractérisé par** la fourniture d'une tranche (1) en silicium ou d'une tranche SOI.

3. Procédé selon la revendication 1 ou 2, **caractérisé en ce qu'**avant l'étape d'application (d), les résonateurs sont soumis à l'étape d'oxydation contrôlée des résonateurs et/ou de dépôt d'oxyde de silicium sur les résonateurs suivie d'un retrait contrôlé d'oxyde de silicium pour doter tous les résonateurs d'une épaisseur de couche d'oxyde de silicium qui rapproche tous les résonateurs des spécifications de référence.

4. Procédé selon l'une quelconque des revendications 1 à 3, dans lequel avant l'étape d'application (d), les groupes sont traités à une fréquence cible, de préférence avec un écart de 1 Hz ou moins.

5. Procédé selon la revendication 4, dans lequel les groupes sont traités par oxydation des résonateurs et/ou dépôt d'oxyde de silicium sur les résonateurs suivis d'un retrait contrôlé d'oxyde de silicium à la fréquence cible.

6. Procédé selon l'une quelconque des revendications 1 à 5, **caractérisé par** l'application des au moins deux masses à partir d'une série de masses (M1-M4) de réglage, dans lequel chacune des masses (M1-M4) présente un centre de masse qui est externe à un centre géométrique de la masse, et les masses (M1-M4) qui sont appliquées au résonateur (G1-G4) sont tournées de façon à régler avec précision le résonateur (G1-G4) plus proche de ses spécifications de référence.

7. Procédé selon l'une quelconque des revendications 1 à 6, **caractérisé par** le fait de prévoir que la série de masses de réglage (M1-M4) couvrent une plage du résonateur (G1-G4) de 15 % max. des spécifications de référence du résonateur (G1-G4).

8. Procédé selon l'une quelconque des revendications 1 à 7, **caractérisé par** le fait de prévoir que des masses (M1, M2 ; M2, M3 ; M3, M4 ; etc.) adjacentes dans la série de masses (M1-M4) de réglage aient des poids différents de façon à permettre un réglage du résonateur (G1-G4) avec un pas de fréquence de 0,5 % des spécifications de référence du résonateur (G1- G4).

9. Procédé selon l'une quelconque des revendications 1 à 8, **caractérisé par** le fait de prévoir que deux masses exactement ou un multiple de deux masses soient appliqués pour régler le résonateur (G1-G4) plus proche de ses spécifications de référence.

10. Procédé selon l'une quelconque des revendications 1 à 9, **caractérisé par** le fait de prévoir que les masses (M1-M4) présentent une tolérance de 10 % par rapport à leur poids de conception.

11. Procédé selon l'une quelconque des revendications 1 à 10, **caractérisé par** le fait de prévoir qu'une plage de réglage de chaque masse (M1-M4) enjambe entre 0 et 50 % une plage de réglage d'une masse adjacente dans la série de masses (M1-M4) de réglage.

12. Procédé selon l'une quelconque des revendications 1 à 11, **caractérisé par** le fait de prévoir qu'un ajout des masses (M1-M4) de réglage au résonateur (G1-G4) augmente un moment d'inertie du résonateur en comparaison au même résonateur sans masses de réglage, d'au moins 1 à 100 %, de préférence de 1 à 30 %.

13. Procédé selon l'une quelconque des revendications 1 à 12, **caractérisé par** l'application sur au moins l'un des résonateurs (G1-G4) de trois masses pour régler la fréquence de résonateur et une sensibilité d'orientation du résonateur.

14. Procédé selon l'une quelconque des revendications 1 à 13, **caractérisé par** l'application sur au moins l'un des résonateurs (G1-G4) de trois masses, dans lequel une masse desdites trois masses est appliquée pour fixer la fréquence du résonateur (G1-G4) proche de ses spécifications de référence, et deux masses desdites trois masses de réglage sont appliquées pour régler avec précision la fréquence du résonateur (G1-G4) encore plus proche des spécifications de référence du résonateur.
